# EUROPÄISCHE PATENTANMELDUNG

(11) **EP 1 162 628 A1**
(43) Veröffentlichungstag der Anmeldung: **12.12.2001**
(21) Anmeldenummer: 00890189.4
(22) Anmeldetag: 08.06.2000
(51) Int. Cl.: H01B 7/08

(54) **Flachbandkabel und seine Verbindung bzw. Kontaktierung**

(71) Anmelder: I & T Innovation Technik Vertriebs-Ges.m.b.H., 7000 Eisenstadt (AT)
(72) Erfinder: Adams, Winfried, 71067 Sindelfingen (DE)
(74) Vertreter: Patentanwälte BARGER, PISO & PARTNER

(57) **Zusammenfassung**

Die Erfindung betrifft Flachbandkabel, auch elektrischer Flachleiter genannt, im wesentlichen bestehend aus einer flexiblen, elektrisch nicht leitenden Trägerfolie (3), auf der elektrisch leitende Leiterbahnen (2) vorgesehen sind, die gegebenenfalls einen im wesentlichen rechteckigen Querschnitt aufweisen und die voneinander isoliert sind, d.h. Abstand voneinander aufweisen und durch zumindest eine elektrisch nicht leitende Abdeckfolie (4), die, bevorzugt mit Hilfe passender Klebstoffe, auf die Trägerfolie und die Leiterbahnen laminiert ist, abgedeckt sind.

Die Erfindung ist dadurch gekennzeichnet, daß die Abisolierung (5) des Flachbandkabels in einem Bereich erfolgt, der im Abstand vom Ende (7) des Flachbandkabels (1) liegt.

Die Erfindung betrifft auch Ausgestaltungen und einen passenden Stecker.

## Beschreibung

Die Erfindung betrifft Flachbandkabel und hier insbesondere dessen Verbindung mit Stekkern oder Klemmleisten od.dgl. zur elektrischen Kontaktierung gemäß dem einleitenden Teil des Anspruches 1.

Elektrische Flachleiter bestehen im wesentlichen aus einer flexiblen Trägerfolie, mit einem darauf aufgebrachten, vorgeformten Leitungssatz. Der Leitungssatz besteht aus einzelnen Leiterbahnen. Die einzelnen Leiterbahnen sind voneinander elektrisch isoliert, d.h. mit Abstand zueinander angeordnet und weisen einen rechteckigen Querschnitt mit zum Teil unterschiedlichen Dimensionen auf und werden deshalb auch als Rechteckleiter bezeichnet. Die Oberseiten der Leiterbahnen sind elektrisch isoliert, wobei insbesondere Folien verwendet werden, die mit Hilfe geeigneter Klebstoffe auf die Leiter und die untere, die Trägerfolie, laminiert werden. Solche flexible Leiter, im Fachjargon FFC (Flexible Flat Cable) genannt, werden in zunehmendem Maße auch als Ersatz herkömmlicher, aus Rundleitern bestehender Kabelbäume im Kraftfahrzeugbau eingesetzt.

Gegenüber herkömmlichen Kabelbäumen ergeben sich bei der Verwendung von FFC verschiedene Vorteile: Durch die Verwendung von Rechteckleitern als Leiterbahnen können bei gleicher Querschnittfläche, verglichen mit Rundleitern, größere Strommengen übertragen werden, womit es insbesondere im Automobilbau zu einer Gewichtsreduktion und Reduktion des Bedarfes an Bauraum kommt. Auch ist die Übersichtlichkeit und insbesondere die flache Ausgestaltung eines solchen Kabelbaumes vorteilhaft, daß ein solcher Kabelbaum auch hinter Verkleidungen mit geringer Bauraumtiefe angebracht werden kann.

Nachteilig bei derartigen Flachbandkabeln ist bisher das Problem der mechanischen Stabilität beim Transport derartiger Flachbandkabel im abisolierten Zustand, da die einzelnen Rechteckleiter keine merkliche mechanische Stabilität aufweisen und sich einer automatisierten Handhabung widersetzen und die elektrische Verbindung solcher Flachbandkabeln mit Platinen in Steuergeräten, mit anderen Flachleitern oder beim Übergang zu herkömmlichen Rundleitern. Auch dabei hat sich die mechanische Anfälligkeit der abisolierten und nicht mehr über das Laminat miteinander verbundenen Rechteckleiter als unangenehm herausgestellt.

Es ist die Aufgabe der vorliegenden Erfindung, eine geeignete Vorbereitung der Flachbänder im Kontaktierungsbereich zu schaffen, durch die ein einfacher und sicherer Transport auch vor der Kontaktierung und eine sichere und dauerhafte Kontaktierung bei gleichzeitiger Zugentlastung und unter Vermeidung von Beschädigungen des Flachbandes beim Handling sichergestellt wird.

Erfindungsgemäß wird diese Aufgabe durch die Maßnahmen des kennzeichnenden Teiles des Anspruches 1 gelöst, nämlich dadurch, daß die Abisolierung des Flachbandkabels in einem Bereich erfolgt, der im Abstand vom Ende des Flachbandkabels liegt. Durch diese Maßnahme wird das eigentliche Ende des Flachbandkabels als Einheit erhalten und weist somit eine im Vergleich zu den einzelnen Leiterbahnen hohe mechanische Stabilität und Formhaltigkeit auf, die auch das Handling beim Einbringen der Leiterbahn in den Stecker merklich erleichtert und zugleich auch das Problem der Zugentlastung der Leiterbahn löst.

Die Erfindung betrifft auch einen Stecker zur sicheren Kontaktierung und Fixierung eines solchen Flachbandkabels, der auch über eine Zugentlastung verfügt.

Erfindungsgemäß wird diese Aufgabe dadurch gelöst, daß der Stecker im Bereich jedes zu kontaktierenden Rechteckleiters, in dem dieser in seinem Endbereich nicht abisoliert ist, über zumindest eine Spitze und/oder zumindest eine im wesentlichen quer zum Rechteckleiter verlaufende Schneide verfügt, die im Zuge der Kontaktierung des Flachbandkabels eine Bewegung zum Rechteckleiter hin vollführt, sodaß die Spitze oder Schneide durch die den Rechteckleiter auf dieser Seite abdeckende Folie hindurch kontaktiert und deformiert.

Auf diese Weise werden die im Betrieb auftretenden Zugkräfte direkt auf die Leiterbahn übertragen und es kommt zu einer ausreichenden Zugentlastung. Durch die Verwendung der erfindungsgemäßen Stecker, die ja in der Praxis immer mehrere Rechteckleiter gemeinsam kontaktieren, wenn auch selbstverständlich elektrisch getrennt voneinander, kommt es noch zu einem Ausgleich eventueller toleranzbedingter, ungleichmäßiger Haltekräfte, da durch den am Ende des Flachbandkabels belassenen Steg der Trägerfolie und der Abdeckfolie ein solcher mechanischer Ausgleich stattfinden kann, was bei Einzelleitern unmöglich wäre.

In einer Ausgestaltung der Erfindung sind die im Stecker befindlichen Kontakte über die Spitze bzw. Schneide geführt und kontaktieren den Rechteckleiter in dem Bereich, in dem die beiden Folien entfernt sind, sowohl von oben als auch von unten. Durch die Bewegung im Bereich der Spitze bzw. Schneide kommt es bei einer bügelförmigen Ausbildung der steckerseitigen Kontakte zu einer leichten schleifenden Bewegung im Zuge des Verriegelns des Steckers, sodaß eventuell an der Oberfläche des Rechteckleiters befindliche Verunreinigungen entfernt werden und die Kontaktierung verbessert wird.

In einer weiteren Ausgestaltung der Erfindung ist vorgesehen, daß die Bauteile, die den Vorsprung bzw. die Schneide und den Leiter tragen, an ihrem, dem Flachband zugekehrten Ende, eine quer zur Richtung der Rechteckleiter verlaufende Riffelung aufweisen, die das Flachbandkabel in dem Bereich kontaktiert, in dem sowohl die Trägerfolie als auch die Abdeckfolie belassen worden sind, somit jenseits des Kontaktfensters. Dadurch kann das Eindringen von Schmutz und Verunreinigungen in den Kontaktbereich vermindert werden und es kommt zu einer zusätzlichen Fixierung des Flachbandkabels im Kontaktbereich, sodaß die eigentliche Kontaktfläche mechanisch nach beiden Seiten abgeschirmt ist.

Die Bewegung des Bauteiles, der die Spitze bzw. Schneide und bevorzugt auch die Kontakte und die Riffelung trägt, kann auf an sich bekannte Weise durch Nocken, durch Keile oder durch Zuklappen des Gehäuses erfolgen und ist für den Fachmann auf dem Gebiete des Steckerbaues kein Problem.

Um einen häufigen Fehler, der bei der Montage von Steckern an Kabelenden, insbesondere unter den erschwerten Einbaubedingungen im Automobilbau immer wieder geschieht, zu verhindern, ist in einer Ausgestaltung der Erfindung vorgesehen, den eigentlichen Stecker in einem Gehäuse anzuordnen und am Gehäuse seitlich Haken anzubringen, die beim Einschieben des Endes des Flachbandkabels vom Isolationssteg, der unmittelbar am Ende des Kabels in einem Bereich von 2 bis 3 mm belassen wurde, verschwenkt werden und dabei das fensterseitige Ende dieses Isolationssteges hintergreifen und in seiner Lage fixieren. Es kann daher aufgrund der Lage dieser zumindest teilweise außerhalb des Gehäuses liegenden Haken auf die richtige Montage des Flachbandkabels im Stecker geschlossen werden, noch bevor dieser geschlossen und fixiert wird.

In einer Ausgestaltung dieser Variante ist vorgesehen, daß durch das Verschwenken der beiden Haken in die Montagelage ein Element, das zur Durchführung der Kontaktierung benötigt wird, beispielsweise einen Arretierstift od.dgl. freigegeben wird, sodaß der Stekker nur dann geschlossen bzw. das eingeschobene Flachbandkabel nur dann fixiert werden kann, wenn es richtig und vollständig in den Stecker eingeschoben ist.

Durch die erfindungsgemäße Maßnahme wird es auch möglich, alle Leiterbahnen oder zumindest eine größere Anzahl von Leiterbahnen eines Flachbandkabels simultan zu kontaktieren, wodurch einerseits die damit verknüpfte Arbeitszeit verkürzt wird, anderseits Fehler vermieden werden können, da das richtige Einbringen des Endes des Flachbandkabels in den Stecker umso besser kontrolliert und überprüft werden kann, je voluminöser und mechanisch stabiler dieses Ende ist.

Die Erfindung ermöglicht auch einen einfachen Übergang auf Rundkabel, da dazu nur die einzelnen Kontakte (Pins) des Steckers mit entsprechenden Litzen eines Rundkabels verbunden sein müssen. Es kann selbstverständlich der Stecker auch direkt Teil einer Platine oder eines Stromverbrauchers sein.

Die Erfindung wird im folgenden an Hand der Zeichnung näher erläutert. Dabei zeigt
die Fig. 1 einen erfindungsgemäß abisolierten Flachbandleiter in Seitenansicht,
die Fig. 2 in Draufsicht und
die Fig. 3 eine schematische Darstellung eines erfindungsgemäßen Steckers für ein erfindungsgemäß abisoliertes Flachbandkabel.

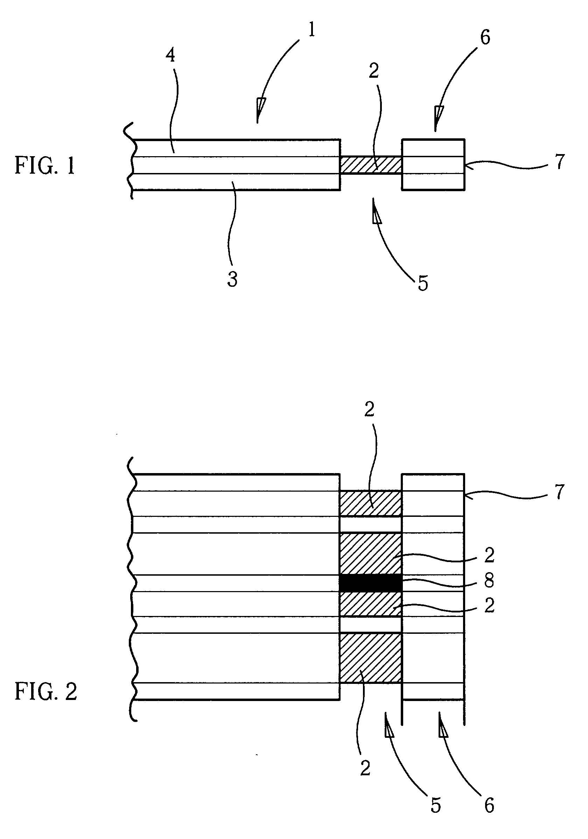

In den Fig. 1 und 2 ist ein erfindungsgemäß abisoliertes Flachbandkabel dargestellt. In seiner Gesamtheit ist der Flachbandleiter mit 1 bezeichnet. Er besteht aus mehreren Leiterbahnen, auch Rechteckleiter genannt, die im gezeigten Ausführungsbeispiel unterschiedliche Breite (Fig. 2), aber gleiche Dicke besitzen. Diese Leiterbahnen 2 sind auf einer Trägerfolie 3 im Abstand voneinander angeordnet, sodaß sie voneinander elektrisch isoliert sind. Die Isolierung wird durch eine Abdeckfolie 4 vervollständigt, die mittels Klebstoff und/oder Erwärmen oder andere Verbindungstechniken auf die Trägerfolie 3 und die Leiterbahnen 2 auflaminiert worden sind.

Erfindungsgemäß wird nun im Abstand vom Ende 7 des Flachleiters sowohl die Trägerfolie 3 als auch die Abdeckfolie 4 in ihrer Gesamtheit entfernt, sodaß nur die unterschiedlich breit dargestellten Rechteckleiter 2, das dadurch gebildete Endstück 6 mit dem eigentlichen Flachleiter 1 verbinden. Dieses nur aus den Leiterbahnen 2 bestehende Stück wird auch als Isolierlücke oder Kontaktfenster 5 bezeichnet.

In den Figuren ist die Dicke der Folien 3 und 4 im Vergleich zur Stärke der Leiterbahnen 2 stark übertrieben dargestellt, doch auch unter Berücksichtigung dieser Verdeutlichung der Verhältnisse wird klar, daß die mechanische Stabilität des Kontaktbereiches 5 im Vergleich zu einem gemäß dem Stand der Technik am Ende 7 abisolierten Flachbandkabel 1 wesentlich vergrößert ist. Insbesondere das Ergreifen und Handhaben der abisolierten Leiterbahnen 2 wird durch das Endstück 6 deutlich erleichtert und das bei einem gleichzeitig verbesserten Schutz gegen jedwede Beschädigung während des Transportes eines bereits abisolierten Flachbandleiters.

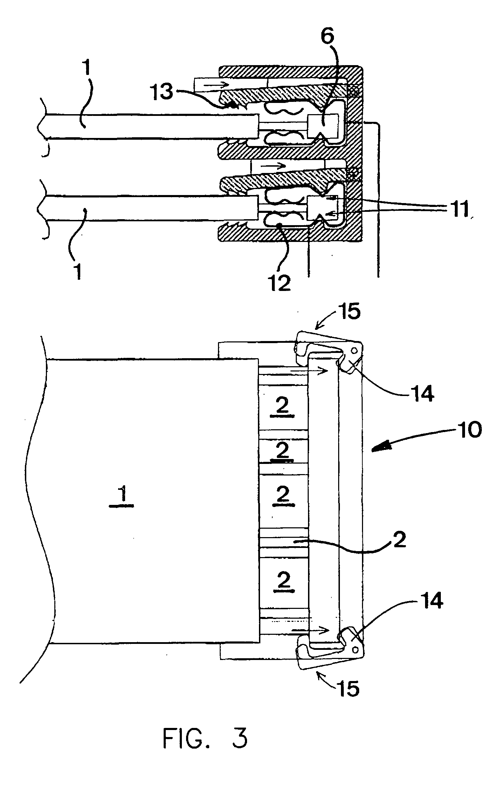

Die erfindungsgemäße Abisolierung von Flachbandleitern ermöglicht auch eine wesentlich verbesserte Kontaktierung dieser Flachbandleiter bzw. von deren Leiterbahnen, beispielsweise durch den in Fig. 3 rein schematisch dargestellten Stecker 10. Dieser Stecker weist Einzelkontakte auf, die äquidistanten Abstand voneinander haben, wie der schematische Schnitt an oberster Stelle der Fig. 3 zeigt. Je nach Breite der zu kontaktierenden Leiterbahnen 2 werden zwei oder auch mehrere dieser Einzelkontakte elektrisch miteinander verbunden und sind so in der Lage gemeinsam auch große Stromstärken zu übertragen, ohne daß für jede Stromstärkenstufe ein eigener Stecker oder ein eigener Kontakt geschaffen und verwendet werden müßte.

Wie aus der mittleren Figur der Fig. 3 hervorgeht, ist im gezeigten Ausführungsbeispiel ein in zwei Ebenen Flachbandleiter 1 kontaktierender Stecker 10 dargestellt, selbstverständlich ist es auch möglich, einen nur in einer Ebene kontaktierenden Stecker zu verwenden bzw. zu schaffen.

Ein Stecker 10 weist in seinem (vom Flachbandkabel 1 aus gesehen) hintersten Bereich eine Spitze oder eine Schneide 11 auf, die beim Schließen des Steckers (darunter wird prinzipiell jede Form des Erfassens des Flachbandkabels und des Kontaktierens verstanden, ob dies nun tatsächlich durch Schließen eines mehrteiligen Gehäuses oder wie im dargestellten Ausführungsbeispiel durch Einschieben von Haltekeilen oder durch Noppen oder wie auch immer erfolgt) durch die Trägerfolie und Abdeckfolie hindurch, bis zur eigentlichen Leiterbahn 2 vordringen, um diese Leiterbahn plastisch deformieren, sodaß mechanische Zugkräfte durch diese Spitzen oder Schneiden 11 direkt auf die metallischen Bauteile des Flachbandkabels übertragen werden.

Im gezeigten Ausführungsbeispiel sind diese Spitzen bzw. Schneiden 11 vom Steckerkontakt 12 überzogen und tragen daher auch zur Kontaktierung bei, was aber nicht notwendig ist. Im gezeigten Ausführungsbeispiel ist diese Variante aber deshalb vorteilhaft, weil durch das Schließen des Steckers 10 und die bügelartige Ausbildung des Steckerkontaktes 12 samt seiner Fixierung im Haltebereich 6 des Flachbandkabels 1 beim Schließen des Steckers zu einer Bewegung der Kontaktflächen des Steckerkontaktes 12 an der Oberfläche der Rechteckleiter 2 kommt und durch diese Bewegung eventuell an den Rechteckleitern anhaftender Schmutz entfernt wird, sodaß zuverlässig eine Metall-Metall-Kontaktierung sichergestellt wird.

Der erfindungsgemäße Stecker, wie er in Fig. 3 dargestellt ist, weist weiters an seiner äußersten, d.h. dem Flachbandkabel 1 zunächst liegenden Seite an seinen aus Kunststoff oder anderem elektrisch nicht leitenden Material bestehenden Bauteilen, die im Zuge des Schließens des Steckers einander angenähert werden, Leisten, Rippen oder Zacken 13 auf. Diese Elemente kontaktieren die Folien 3, 4 (Fig. 1) des Flachbandkabels 1 und dringen leicht in dessen Oberfläche ein. So sorgen sie einerseits für einen bestmöglichen Abschluß des Kontaktbereiches vor Umwelteinflüssen, anderseits für eine Zugübertragung auch auf die Kunststoffteile des Flachbandkabels 1.

In einer besonderen Ausgestaltung, die der untersten Darstellung der Fig. 3 zu entnehmen ist, ist zu sehen, daß das Gehäuse des Steckers 10 seitlich Haken aufweist, die beim Einschieben des Halte- und Isolierteiles 6 in den Stecker 10 durch das Anstoßen auf Vorsprünge der Haken 14, diese so verdrehen, daß die eigentlichen Hakenenden hinter (in Einschubrichtung gesehen) den Isolierabschnitt 6 gelangen und so diesen Abschnitt zusätzlich zu all den anderen Maßnahmen am Herausziehen hindern. In einer nicht dargestellten Ausführungsform wird das Schließen des Steckers 10 erst nach vollständigem Einschwenken der Haken 14 in Richtung der Pfeile 15 möglich. Dies kann beispielsweise durch Vorsprünge, Stifte, Leisten, Nocken od.dgl. geschehen, die erst mit erfolgtem vollständigem Einschwenken der Haken 15 in Bereiche zu liegen kommen, in denen das Gehäuse des Steckers 10 entsprechende Ausnehmungen aufweist, die das Schließen gestatten.

Die Erfindung ist nicht auf das dargestellte Ausführungsbeispiel beschränkt, sondern kann verschiedentlich abgewandelt und verändert werden. So ist es nicht notwendig, daß die Leiterbahnen unterschiedliche Breite besitzen oder auch, daß sie gleiche Höhe besitzen, wenn dies auch wegen der vereinfachten Kontaktierung in den erfindungsgemäßen Stekkem bevorzugt wird. Es ist selbstverständlich möglich, daß mehr oder weniger Leiterbahnen als dargestellt vorgesehen werden und es ist selbstverständlich möglich, daß die gesamten Dimensionen anders als dargestellt sind. Auch ist es möglich, mehrere Träger-und/oder Abdeckfolien vorzusehen, wenn, aus welchen Gründen auch immer, besondere mechanische Stabilität gewünscht ist.

Wesentlich ist, daß unmittelbar am Ende 7 des Flachbandleiters ein Bereich über zumindest den Großteil seiner Breite besteht, in dem zumindest einige der Rechteckleiter 2 sowohl an ihrer Oberseite als auch an ihrer Unterseite von zusammenhängenden Folien bedeckt werden und daß im Abstand vom Ende 7 ein Bereich besteht, in dem diese Rechteckleiter 2 an der Ober und/oder Unterseite frei von jeder Folie sind.

Der erfindungsgemäße Stecker kann selbstverständlich vielfach variiert werden, so ist es beispielsweise möglich, zur Verbindung von Flachkabel zu Flachkabel, beispielsweise zu Reparaturzwecken, eine Art _{"}Doppelstecker" vorzusehen, der beidseits mit erfindungsgemäßen Kontakten und gegebenenfalls auch mit entsprechenden Haken für beide Flachkabel versehen ist. Selbstverständlich sind auch Übergänge auf Rundkabel oder direkt auf Platinen ohne weiteres möglich.

## Patentansprüche

1. Flachbandkabel, auch elektrischer Flachleiter genannt, im wesentlichen bestehend aus einer flexiblen, elektrisch nicht leitenden Trägerfolie (3), auf der elektrisch leitende Leiterbahnen (2) vorgesehen sind, die gegebenenfalls einen im wesentlichen rechteckigen Querschnitt aufweisen und die voneinander isoliert sind, d.h. Abstand voneinander aufweisen und durch zumindest eine elektrisch nicht leitende Abdeckfolie (4), die, bevorzugt mit Hilfe passender Klebstoffe, auf die Trägerfolie und die Leiterbahnen laminiert ist, abgedeckt sind, **dadurch gekennzeichnet, daß** die Abisolierung (5) des Flachbandkabels in einem Bereich erfolgt, der im Abstand vom Ende (7) des Flachbandkabels (1) liegt.

2. Flachbandkabel nach Anspruch 1, **dadurch gekennzeichnet, daß** die Abisolierung beidseits erfolgt, somit sowohl die Trägerfolie (3) als auch die Abdeckfolie (4) erfaßt.

3. Flachbandkabel nach Anspruch 1 oder 2, **dadurch gekennzeichnet, daß** am Ende (7) des Flachbandkabels ein Isoliersteg (6) belassen wird, dessen Erstreckung in Richtung der Leiterbahnen etwa 1 bis 10, bevorzugt 2 bis 4 mm beträgt.

4. Stecker zur Kontaktierung eines Flachbandkabels nach einem der Ansprüche 1 bis 3, **dadurch gekennzeichnet, daß** der Stecker (10) im Bereich jedes zu kontaktierenden Rechteckleiters (2) du zwar in dessen Isolierbereich (6), über zumindest eine Spitze und/oder zumindest eine im wesentlichen quer zum Rechteckleiter (2) verlaufende Schneide (11) verfügt, die im Zuge der Kontaktierung des Flachbandkabels (1) eine Bewegung zum Rechteckleiter (2) hin vollführt, sodaß die Spitze und/oder Schneide (11) durch die den Rechteckleiter (2) auf dieser Seite abdeckende Folie (3;4) hindurch kontaktiert und deformiert.

5. Stecker nach Anspruch 4, **dadurch gekennzeichnet, daß** zumindest eine Spitze bzw. Schneide (11) vom Steckerkontakt (12) überzogen sind.

6. Stecker nach Anspruch 4 oder 5, **dadurch gekennzeichnet, daß** es durch das Schließen des Steckers (10) und die bügelartige Ausbildung des Steckerkontaktes (12) samt seiner Fixierung im Isolierbereich (6) des Flachbandkabels (1) zu einer Bewegung der Kontaktflächen des Steckerkontaktes (12) an der Oberfläche der Rechteckleiter (2) kommt.

7. Stecker nach einem der Ansprüche 4 bis 6, **dadurch gekennzeichnet, daß** er ein Gehäuse besitzt, das seitlich Haken (15) aufweist, die beim Einschieben des Halte- und Isolierteiles (6) in den Stecker (10) durch Anschläge (14) so verdreht werden, daß die Hakenenden, in Einschubrichtung gesehen hinter den Isolierabschnitt (6) gelangen.

8. Stecker nach Anspruch 7, **dadurch gekennzeichnet, daß** Vorsprünge, Stifte, Leisten, Nocken od.dgl. vorgesehen sind, die erst mit erfolgtem vollständigem Einschwenken der Haken (15) in eine Position gelangen, in der das Gehäuse des Steckers (10) korrespondierende Ausnehmungen aufweist, die das Schließen gestatten.
